(19) Europäisches Patentamt / European Patent Office / Office européen des brevets

(11) **EP 3 048 450 B1**

(12) **EUROPEAN PATENT SPECIFICATION**

(45) Date of publication and mention
of the grant of the patent:
**10.03.2021 Bulletin 2021/10**

(21) Application number: **15152056.6**

(22) Date of filing: **22.01.2015**

(51) Int Cl.:
*G01R 31/36* (2020.01)          *B60L 58/13* (2019.01)
*B60L 58/16* (2019.01)          *G01R 31/3842* (2019.01)
*B60L 3/12* (2006.01)

(54) **System and method for determining battery usage limits**

System und Verfahren zur Bestimmung der Verbrauchsgrenzen einer Batterie

Système et procédé permettant de déterminer des limites d'utilisation d'une batterie

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.07.2016 Bulletin 2016/30**

(73) Proprietor: **Volvo Car Corporation**
**40531 Göteborg (SE)**

(72) Inventors:
 • **Kuusisto, Hannes**
 **41830 Göteborg (SE)**

 • **Håkansson, Dag**
 **43164 Mölndal (SE)**

(74) Representative: **Kransell & Wennborg KB**
**P.O. Box 2096**
**403 12 Göteborg (SE)**

(56) References cited:
**EP-A2- 2 339 361          US-A1- 2013 043 844**
**US-A1- 2013 124 029          US-A1- 2014 132 214**
**US-A1- 2014 232 356**

## Description

Field of the Invention

The present invention relates to a system and a method for determining a usage limit for an energy storage device.

Background

Electric and hybrid vehicles have recently become a more common sight on roads worldwide. They have one thing in common and that is they all require large and powerful rechargeable energy storage, for example a rechargeable battery. Such rechargeable batteries have a limited runtime every time it is recharged and a user typically has a way of monitoring an estimated currently available energy of the battery (e.g. in the form of estimated range reachable with the presently available energy).

The available power/energy (e.g. the state of charge) is an important characteristic to monitor during operation of the vehicle. A battery management system of the vehicle typically continuously monitors ("online") the currently available power. Furthermore, the state of charge of the battery is important to monitor in order for a user to know for example the available driving range using the battery or performance of the battery. However, it is also important not to violate certain usage limits of the battery. For example, in order not to damage the battery there is commonly a lower and an upper limit on the state of charge. These limits may typically be pre-set by the manufacturer. In order not to risk high warranty costs due to damaged batteries, the usage limits are typically conservatively set.

EP2502775 discloses an example of a method for determining user limits for a battery based on travel distance and/or battery age. In EP2502775, the changes in limits are based on a predefined schema specifying increases in user limits to e.g. specific battery age. However, with such schema based increases in user limits, the full-life performance potential of the battery and thereby of the vehicle may be reduced or at least not fully utilized.

There is therefore a need to improve the accuracy in determining user limits of an energy storage device.

US2014/0132214 discloses an apparatus and method which intends to protect the power storage, e.g. a battery, within an electrical vehicle from exceeding an upper limit of a predetermined state of charge (SOC) during charging by an external power structure. A control device increases the upper limit as the deterioration of the battery progresses.

US2013/0043844 discloses a control device for controlling the charging/discharging of an electric power storage device.

US2014/0232356 discloses various methods for battery management of an electric vehicle EP2339361 discloses to determine a solution resistance and a charge transfer resistance of a battery. A present value indicator calculating unit acquires history information containing battery capacities at respective C-rates representing characteristics of the battery and $R_{sol}$ and $R_{ct}$. The unit compares the history information to reference deterioration data.

Summary of the Invention

In view of the above, it is a general object of the present invention to provide a method and a system which improves the full-life potential of an energy storage device connected to an electric motor arranged to provide propulsion for an electric or hybrid vehicle.

According to a first aspect it is therefore provided a method for determining a usage limit for an energy storage device arranged to provide energy to a according to claim 1 or alternatively according to claim 16.

The energy storage device is arranged to provide energy for propulsion of the electric or hybrid vehicle.

The value of the travel parameter may be determined from a first day of usage of the energy storage device. The first day of usage may be the day when the energy storage device is first mounted and installed in the vehicle. Installation may for example include installing the appropriate software for controlling the energy storage device. The first day of usage may alternatively be for example the first day of usage after the manufacturing of the energy storage device or the first day of usage from when a user first operates the vehicle with the energy storage device. Thereby, the term "usage" should be interpreted broadly and includes operating the energy storage device such that an electrical current is run through the energy storage device, and also includes to only leaving the energy storage device in the vehicle after the first day. For example, an energy storage device ages even if electrical current is not passed through it due to e.g. an elevated temperature (e.g. due to leaving the vehicle in hot sun) of the energy storage device. For example, in embodiments of the invention, the travel parameter may be a travelled distance of the vehicle or a total power or energy usage of the energy storage device. The travelled distance may for example be in kilometers, and the total power usage may for example be given by ampere hours (Ah) or kilowatt hours (kWh) of usage of the energy storage device. The travelled distance or total power usage may be provided by an electric control unit (ECU) in the vehicle. The travelled distance may be provided by a distance measurement unit of e.g. an electronic control unit (ECU) of the vehicle.

The historical data may be in the form of operating parameter vs. age (or vice versa) or operating parameter vs. travel parameter (or vice versa). Or, preferably, the historical data may be in the form of variation in operating parameter vs. age (or vice versa) or variation in operating parameter vs. travel parameter (or vice versa). Thus from the historical data, an estimated variation of an operating parameter related to an age or travel parameter may be established.

The actual variation in operating parameter is determined from data collected by the vehicle (i.e. by sensors and a control unit in the vehicle) during operation of the vehicle. The actual variation in operating parameter is determined for the same amount of time as for determining the age or travel parameter of the energy storage device described above with reference to the travel parameter.

The age since manufacturing of the energy storage device should be interpreted broadly, but may comprise determining the age since completion of the manufacturing of the energy storage device. However, additions to the completion of manufacturing such that the age also comprises the time of manufacturing, will only add an offset to the age and may also be possible to include when determining the age.

The difference between the actual variation and the first or second operating parameter variation may be based on a subtraction between the actual variation and the first or second operating parameter variation. Alternatively, the difference between the actual variation and the first or second operating parameter variation may be based on a relative difference (e.g. a ratio or a percentage) between the actual variation and the first or second operating parameter variation.

The predefined set of user limit adjustments may be provided as e.g. a table with the set of user limit adjustments and respective operating parameter variation differences.

The present invention is based on the realization that user limits of an energy storage device may be adapted such as to increase the available power/energy to a user by utilizing the actual usage of the energy storage device. The user limits of the energy storage device may be determined based on how much the user operates the vehicle, and also take into account how aggressively the vehicle is driven. Thus, the variation in an operating parameter of the energy storage device is related and compared to historical data which provides a way to evaluate how aggressively the energy storage device is used and to adjust the user limits accordingly.

According to an embodiment of the invention, the operating parameter may be a capacity of the energy storage device. A capacity of an energy storage device may generally be described with the unit ampere seconds (As), thus the capacity is the available ampere-seconds. Of course other alternatives also exist, for example the capacity may be described as the available power in the energy storage device. Alternatively or additionally, the operating parameter may be an internal electrical resistance of the energy storage device.

In the case of the operating parameter being a capacity of the energy storage device, the variation of an operating parameter may be a capacity loss. Naturally, during usage of the energy storage device, a loss in capacity occurs from draining the power/energy stored in the energy storage device. The loss may be determined as a percentage of variation from a previous capacity.

According to an embodiment of the invention, the method may comprise: determining both of the value of the travel parameter and the age, determining both of the first variation of the operating parameter and the second variation of the operating parameter, determining both of the first operating parameter variation difference and the second operating parameter variation difference, choosing one of the first operating parameter variation difference and the second operating parameter variation difference according to a predefined criterion, wherein, for the chosen operating parameter variation difference, determining the usage limit adjustment from the set of predefined usage limit adjustments. Thus, in this embodiment, the method may be a method for determining a usage limit for an energy storage device arranged to provide energy to a vehicle, the method comprising the steps of:

determining a value of a travel parameter of the energy storage device, the value of the travel parameter being related to an amount of usage of the energy storage device, and determining an age since manufacturing of the energy storage device,

estimating a first variation of an operating parameter of the energy storage device based on the value of the travel parameter from a first set of historical data relating the operating parameter to the travel parameter, and a second variation of the operating parameter of the energy storage device based on the age of the energy storage device from a second set of historical data relating the operating parameter to an age of an energy storage device,

estimating an actual variation of the operating parameter for the energy storage device based on data related to actual usage of the energy storage device in the vehicle, the data being provided by a control unit in the vehicle,

calculating a first operating parameter variation difference between the actual variation and the first variation of the operating parameter, and calculating a second operating parameter variation difference between the actual variation and the second variation of the operating parameter, choosing one of the first operating parameter variation difference and the second operating parameter variation difference according to a predefined criterion, wherein, for the chosen operating parameter variation difference, determining the usage limit adjustment from the set of predefined usage limit adjustments, determining the usage limit by adjusting a previous usage limit based on the usage limit adjustment. By including a calculation of both the first and the second operating parameter variation differences and subsequently choosing only one of them according to the criterion, more flexibility is enabled in determining the usage limit adjustment.

According to an embodiment of the invention, if the operating parameter is a capacity of the energy storage device, the first variation may be a first capacity loss, the second variation may be a second capacity loss, the actual variation is an actual capacity loss, thereby the first capacity variation difference may be a first capacity loss difference and the second capacity variation difference may be a second capacity loss difference, wherein the step of choosing according to a predefined criterion includes:
choosing the smallest one of the first capacity loss difference and the second capacity loss difference. By choosing the smallest one of the capacity loss differences, the user limit adjustment may be determined such that an optimized adjustment of the previous user limit may be performed. For example, since the smallest one of the capacity loss differences is chosen, a user limit may be adjusted more than if the larger of the two is chosen. Thus, with the smaller one, there is more "room" for adjustment since a smaller capacity loss difference naturally indicates a less aggressive usage of the energy storage device. Thereby, the usage potential over the lifetime of the energy storage device is further improved.

The operating parameter may in an alternative embodiment be an electrical resistance increase of the energy storage device. In such case the variation of an operating parameter is an electrical resistance variation. Furthermore, if the operating parameter is an electrical resistance of the energy storage device, the first variation is a first electrical resistance variation, the second variation is a second electrical resistance variation, the actual variation is an actual electrical resistance variation, wherein the step of choosing according to a predefined criterion includes: choosing the largest one of the first electrical resistance variation difference and the second electrical resistance variation difference. Note that the electrical resistance variations (first and second), may be negative or positive. Furthermore, also the electrical resistance variation differences (first and second) may be negative or positive. Thus, when choosing the largest one of the first electrical resistance variation difference and the second electrical resistance variation difference, also the sign counts. For example an electrical resistance variation difference of -2 Ohm is larger than an electrical resistance variation difference of -3 Ohm.

According to another embodiment of the invention, the method may further comprise:

measuring an electrical current ($i_k$) through the energy storage device,
estimating a total electrical current ($I_{k+1}$) based on a previously determined electrical current ($I_k$), the measured electrical current *(ik)* and a formula,
if the total current is below a predefined electrical current limit, increase the usage limit.

Thus, as an additional criterion to adjusting the user limit, an electrical current through the energy storage device may be estimated. This enables an improved estimation of driving behavior of the user of the vehicle being power by the energy storage device. For example, a user who doesn't use the energy storage device much may be rewarded with e.g. an increased user limit which may result in increased driving range of the vehicle. The total electrical current may according to an embodiment of the invention be given by the formula:

$$I_{k+1} = \sqrt{wI_k + i_k^2(1-w)}$$

where $I_k$ is the calculated total current in the k-th calculation, $i_k$ is a measured current through the energy storage device, and $w = \tau/(\tau + T)$ where $\tau$ is a time constant and T is the time from a first calculation of a first total electrical current with the formula to a second calculation of a second total electrical current with the formula, and the time between measurements of the measured current ($i_k$, $i_{k+1}$) for the first and the second total electrical currents, respectively. This formula may be run every time the user stops the vehicle. The time constant may be e.g. between 20-80 hours of driving time but is not limited to this range.

In some situations, the usage limit may only be increased if the age of the energy storage device is smaller than a predetermined value. For example, if the age of the energy storage device exceeds ten years, the user limits may be adjusted more conservatively, or even not adjusted at all.

According to an embodiment of the invention, the method may further comprise a step of comprising a step of monitoring a temperature of the energy storage device, wherein each of the first and/or second variation of the operating parameter of the energy storage device is determined from more than one set of historical data associated with a respective temperature. In other words, the historical data may be different depending on the temperature of the energy storage device. Thus, the relation between the operating parameter and the age and/or the travel parameter may be weighted by combining several sets of historical data obtained at difference temperatures. For example, if the energy storage device has been at temperature $T_1$ during 70% of the aging time and at $T_2$ during 30% of the aging time, then for the first 70% of the time, the operating parameter variation (e.g. from $R_0$ to $R_1$) is obtained from a first set of historical data corresponding to temperature $T_1$, and for the remaining 30% of the time the operating parameter variation (e.g. from $R_1$ to $R_2$) is obtained from a second set of historical data corresponding to temperature $T_2$. The total operating parameter variation is then obtained from the resulting total operating parameter variation (in this case from $R_0$ to $R_2$).

According to yet another embodiment of the invention, the first and second set of historical data may be based on experimental usage data from a plurality of energy storage devices. Thus, the historical data may be collected from previous measurements of operating parameter vs. age (or vice versa) or operating parameter vs. travel parameter (or vice versa). Or, preferably, the historical data may be collected from previous measurements of variation in operating parameter vs. age (or vice versa) or variation in operating parameter vs. travel parameter (or vice versa). For example, measurements on hundreds or even thousands or energy storage devices may be comprised in the historical data. This way, an accurate estimation of the first and second variation in operating parameter may be provided.

According to embodiments of the invention, the usage limit may be an upper state of charge limit, or a lower state of charge limit, or an upper voltage limit, or a lower voltage limit, or an upper current limit, or a lower current limit or an upper power limit or a lower power limit. A state of charge is given as the percentage of the charge state of the energy storage device, e.g. an empty energy storage device has state of charge 0% and a full energy storage device has state of charge 100%. The mentioned usage limits may also have temperature dependence. Thus, a step of measuring the temperature of the energy storage device may be included.

According to a second aspect it is provided a system for determining a usage limit for an energy storage device arranged to provide energy to a vehicle according to claim 12 or alternatively according to claim 17.

The electric current sensor and the electric voltage sensor may be a single sensor or sensor unit for determining a capacity of the energy storage device or power usage of the energy storage device, or the sensors are separate sensors.

According to example embodiments of the invention, the control unit may be configured to estimate both the first and the second variation of the operating parameter, and to calculate both the first and the second operating parameter variation difference, and to choose of the first and the second operating parameter variation difference according to a predefined criterion, and based on the chosen operating parameter variation difference, determining an usage limit adjustment from a set of predefined usage limit adjustments.

The control unit is preferably a micro processor or any other type of computing device. Similarly, the data storage may be any type of memory device, including one of a removable nonvolatile/volatile random access memory, a hard disk drive, a floppy disk, a CD-ROM, a DVD-ROM, a USB memory, an SD memory card, or a similar computer readable medium known in the art. The energy storage device may be a rechargeable battery such as a Li-ion battery. The control unit may be part of a battery management system of the vehicle.

The system may further comprise the energy storage device.

According to an embodiment of the invention, the system may further comprise a temperature sensor arranged to measure the temperature of the energy storage device, wherein the control unit is configured to receive temperature data from the temperature sensor, and wherein to estimate the actual variation of the operating parameter is based at least partly on the received temperature data.

The system according to embodiment of the invention is advantageously arranged in a vehicle. Preferably the energy storage device of the system is arranged to provide propulsion for the vehicle which may be an electric or hybrid vehicle.

Further effects and features of this second aspect of the present invention are largely analogous to those described above in connection with the first aspect of the invention.

Further features of, and advantages with, the present invention will become apparent when studying the appended claims and the following description. The skilled person realizes that different features of the present invention may be combined to create embodiments other than those described in the following, without departing from the scope of the present invention.

Brief Description of Drawings

These and other aspects of the present invention will now be described in more detail, with reference to the appended drawings showing a currently preferred embodiment of the invention, wherein:

> Fig. 1 schematically shows an exemplary application for an exemplary embodiment of an energy storage enclosure;
> Fig. 2 shows an exemplary system according to an embodiment of the present invention;
> Fig. 3 provides a flow-chart of method steps according to an exemplary embodiment of the present invention;
> Fig. 4 and Fig. 5 show exemplary historical data;
> Fig. 6 provides a flow-chart of method steps according to an exemplary embodiment of the present invention;
> Fig. 7 illustrates an exemplary table comprising predefined usage limit adjustments;
> Fig. 8a-b each shows exemplary historical data obtained at different temperatures of an energy storage device; and
> Fig. 8c illustrates combined historical data based in the historical data shown in Figs. 8a-b.

Detailed Description of Embodiments of the Invention

In the following description, the present invention is mainly described with reference to an energy storage device arranged in an electric or hybrid vehicle in the form of a car. However, the invention may be applied to any type of electric vehicle (having an energy storage device) such as a truck, a fork lift, a boat, etc.

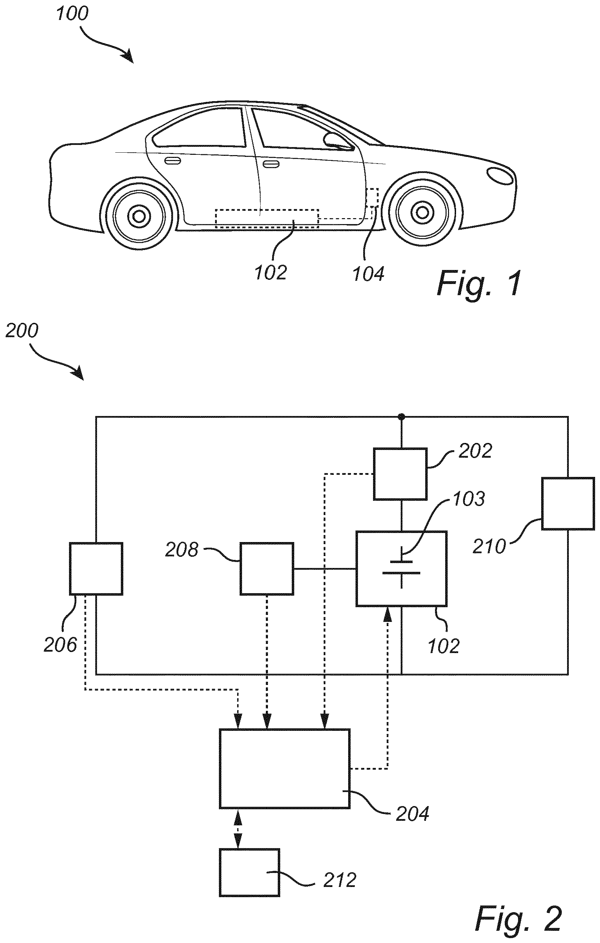

Fig. 1 illustrates an exemplary application for a system according to an embodiment of the invention. In Fig. 1 there is shown a vehicle 100 in the form of a hybrid or electric car 100 comprising a rechargeable battery 102 connected to an electric motor arranged to provide propulsion for the vehicle 100. In the vehicle 100 there is further a battery management system 104 for controlling the rechargeable battery 102 and monitoring the operation and status of the battery 102. The system according to the invention may be part of the battery management system 104. The rechargeable battery 102 may be a Li-ion battery.

Fig. 2 schematically illustrates an exemplary system 200 according to an embodiment of the invention. In Fig. 2, the system 200 comprises an electric current sensor 202 and a control unit 204 in the form of a processor 204 connected to the electric current sensor 202 such that the processor 204 may receive signals from the electric current sensor 202. The signals may comprise electric current data of the battery 102 measured by the electric current sensor 202. The battery 102 may comprises several battery cells 103 which may be Li-ion cells. The processor 204 may be part of the battery managements system 104, but may also be a control unit external to the battery management system 104. There may further be an additional sensor 206 for measuring a voltage of the battery 102 and a temperature sensor 208 for measuring a temperature of the battery 102. Both the voltage sensor 206 and the temperature sensor 208 are connected to the processor 204 and may provide battery voltage data and temperature data respectively to the processor 204. The voltage data and the temperature data may be used for improving the estimation of operating parameters of the battery 102. The voltage sensor provides voltage data which together with current data may be used for obtaining a power usage of the battery. The temperature sensor may measure the temperature of an individual cell 103 of the battery 102. The temperature is useful to know since the battery 102 may for example age differently depending on the ambient temperature of the battery 102. The battery 102 may be connected to a load 210 which may be an electric motor 210 of the vehicle for providing propulsion to the vehicle. Thus, the battery 102 is configured to power the electric motor 210. Furthermore, the battery 102 may be a rechargeable battery 102. The processor 204 may be configured to control the amount of power that the load 210 can use. Thus, the processor 204 may provide information to the load 210 regarding the amount of power the load 210 may use.

The processor 204 is connected and in communication with a data storage 212. The data storage 212 has stored a first set of historical data relating an operating parameter of the battery 102 to a travel parameter of battery 102. The data storage 212 also has stored a second set of historical data relating the operating parameter to an age of the battery 102. The first and the second set of historical data are based on experimental usage data from a plurality of rechargeable batteries.

The processor 204 may be configured to determine a travel parameter value related to an amount of usage of the battery 102. The travel parameter may be a travelled distance of the vehicle or a total power usage of the energy storage device. The travelled distance may for example be in kilometers, and the total power usage may for example be given by ampere hours (Ah) or kilowatt hours (kWh) of usage of the energy storage device. The travelled distance or total power usage may be provided by an electric control unit (ECU) in the vehicle, alternatively or additionally the travelled distance or total power usage may be provided by the control unit 204. For example, the ECU may have a distance measurement unit which may provide information regarding a travelled distance. Distance measurement units are standard equipment in most vehicles. Next the control unit estimates a first variation of an operating parameter of the battery 102 based on the travel parameter value from the first set of historical data, and/or a second variation of the operating parameter of the energy storage device based on the age of the energy storage device from the second set of historical data. Based on the electric current data received by the processor 204 from the electric current sensor 202 and voltage data received from the voltage sensor 206, the processor 204 estimates an actual variation of the operating parameter for the battery 102. Furthermore, the processor 204 calculates a first operating parameter variation difference between the actual variation and the first estimated variation of the energy storage device and/or a second operating parameter difference between the actual variation and the second estimated variation of the operating parameter. In embodiments of the invention, the processor 204 is configured to choose one of the first operating parameter variation difference and the second operating parameter variation difference according to a predefined criterion. For example the processor 204 may choose the smallest one of the first and the second operating parameter variation difference. The processor 204 is further configured to determine a usage limit adjustment from the set of predefined usage limit adjustments based on the chosen operating parameter variation difference, or based on either the first or the second operating parameter variation difference. The set of predefined usage limit adjustments may be stored in the data storage 212 and may be received by the processor 204 from the data storage 212. Next, the processor 204 determines the usage limit by adjusting a previous usage limit stored on the data storage based on the usage limit adjustment. The system 200 may be arranged in the vehicle 100. The system 200 may be part of a battery management system 104 of the vehicle.

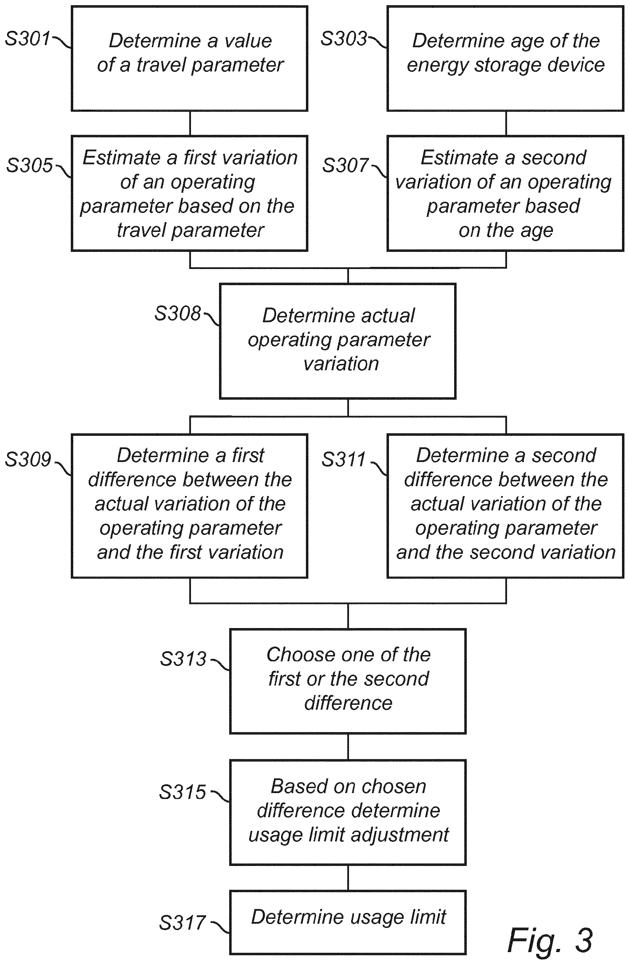

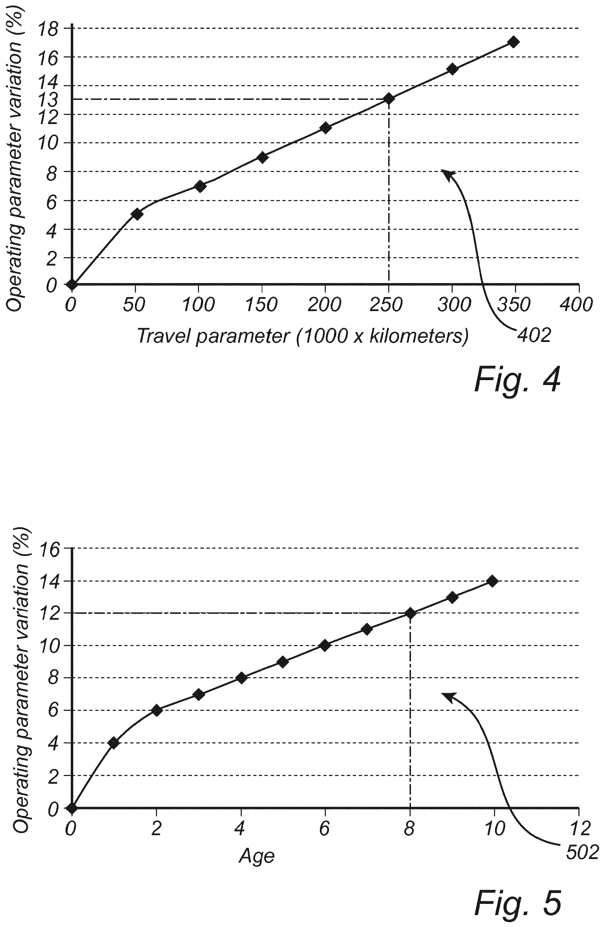

Fig. 3 provides a flow-chart of method steps according to an embodiment of the invention. The exemplary method may be implemented in the system 200 as described with reference to Fig. 2. In a first step S301, a value of a travel parameter of the battery 102 is determined. The travel parameter may for example be a travelled distance using the battery 102 or a power usage (e.g. Ah or kWh) of the battery 102. For example, in the case of a hybrid vehicle it may be more advantageous to use power usage as the travel parameter since the usage of the battery with respect to travelled distance is relatively difficult to estimate in a hybrid vehicle compared to power usage. However, even in the case of a hybrid vehicle travelled distance may be used. For example, in case of a hybrid vehicle the travelled distance may be weighted with the amount of usage (e.g. power) for subsections of the travelled distance. In an electric vehicle, either travelled distance using the battery 102 or a power usage (e.g. Ah or kWh) of the battery 102 may be used equally well. In step S303 an age of the battery 102 is determined. The age may be from the manufacturing of the battery 102. In subsequent step S305 it is estimated a first variation of an operating parameter of the battery 102 based on the value of the travel parameter from a first set (see Fig. 4) of historical data relating the operating parameter to the travel parameter.

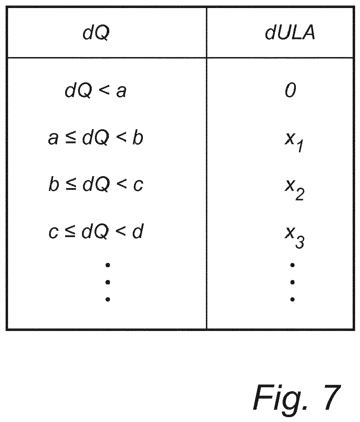

Furthermore, in step S307 it is estimated a second variation of the operating parameter of the battery 102 based on the age of the battery 102 from a second set (see Fig. 5) of historical data relating the operating parameter to an age of a battery. In step S308, an actual operating parameter variation is determined. The actual operating parameter variation may be determined by the control unit 204 arranged in the vehicle 100. Subsequently in step S309 a first operating parameter variation difference (dQ1) is calculated between an actual variation of the operating parameter and the first variation of the operating parameter. Furthermore, in step S311 a second operating parameter variation difference (dQ1) is calculated between the actual variation of the operating parameter and the second variation of the operating parameter. Based on a predefined criterion, one of the first and the second operating parameter variation difference is chosen in step S313. The criterion may for example be (but is not limited to) the smallest one of the first (dQ1) and the second (dQ2) operating parameter variation difference. In step S315, a usage limit adjustment is determined from a set of predefined usage limit adjustments. The predefined usage limit adjustments are related to the chosen operating parameter variation difference. For example, the predefined usage limit adjustments may be stored in a table (e.g. in data storage 212) together with respective operating parameter variation differences. This way, an operating parameter variation difference has a corresponding predefined usage limit adjustment. The table may thus be in the form of a look-up table as shown in Fig. 7 illustrating a look-up table of operating parameter variation differences dQ (thus, dQ1 or dQ2) and usage limit adjustments dULA. Finally, in step S317 a usage limit is determined by adjusting a previous usage limit based on the usage limit adjustment. The adjustment may be to increase the usage limit from the previous usage limit.

Note the method is applicable also when using only one of the two branches of the flowchart. For example, in a first step S301, a value of a travel parameter of the battery 102 is determined. In subsequent step S305 it is estimated a first variation of an operating parameter of the battery 102 based on the value of the travel parameter from a first set (see Fig. 4) of historical data relating the operating parameter to the travel parameter. In step S308, an actual operating parameter variation is determined. Subsequently in step S309 a first operating parameter variation difference (dQ1) is calculated between an actual variation of the operating parameter and the first variation of the operating parameter. In step S315, a usage limit adjustment is determined from a set of predefined usage limit adjustments. The predefined usage limit adjustments are in this case related to the first operating parameter variation difference. Finally, in step S317 a usage limit is determined by adjusting a previous usage limit based on the usage limit adjustment.

Alternatively, the steps of the other branch of the flow-chart in Fig. 3 is used. In this case, in a first step S303, an age of the battery 102 is determined. In subsequent step S307 it is estimated a second variation of an operating parameter of the battery 102 based on the age from a second set (see Fig. 5) of historical data relating the operating parameter to the age of the battery. In step S308, an actual operating parameter variation is determined. Subsequently in step S311 a first operating parameter variation difference (dQ1) is calculated between an actual variation of the operating parameter and the second variation of the operating parameter. In step S315, a usage limit adjustment is determined from a set of predefined usage limit adjustments. The predefined usage limit adjustments are in this case related to the second operating parameter variation difference. Finally, in step S317 a usage limit is determined by adjusting a previous usage limit based on the usage limit adjustment. Note that when only using one of the branches, the step S315 of choosing may be omitted.

The operating parameter may be a capacity of the battery 102 or an internal electrical resistance of the battery 102. In the case of a capacity, the variation of an operating parameter is a capacity loss. Thus, in step S305 and S307, a first and a second capacity loss is estimated from the two sets of historical data. Furthermore, when determining a first and a second operating parameter variation difference, in the case of capacity and thus capacity loss, the first capacity variation difference is a first capacity loss difference (dQ1) and the second capacity variation difference is a second capacity loss difference (dQ2). In this case, the step S313 comprises choosing the smallest one of the first and the second capacity loss difference.

Furthermore, the usage limit may be one of the following: an upper state of charge limit, or a lower state of charge limit, or an upper voltage limit, or a lower voltage limit, or an upper current limit, or a lower current limit or an upper power limit or a lower power limit of the energy storage device 102. Moreover, the adjustment of the usage limit may be to decrease or to increase the previous usage limit.

Fig. 4 illustrates a graph of exemplary historical experimental data 402 of an operating parameter variation as a function of a travel parameter. In this case, the operating parameter variation may be a capacity loss of the battery 102 and the travel parameter may be a travelled distance (in kilometers) of the vehicle using the battery 102. This data shown in Fig. 4 may be an average data based on experimental data from a plurality of batteries. Such data may thus be experimental usage data from a plurality of batteries, for example from hundreds or even thousands of batteries. As an example, in the step of estimating a first variation based on a value of a travel parameter, if the travel parameter (in this example) is 250 000 kilometers, thus it is received from a control unit in the vehicle that the travel parameter is 250 000 kilometers, from the historical data 402 it is found that the operating parameter variation is about 13%.

Similar to Fig. 4, Fig. 5 illustrates a graph of exemplary historical experimental data 502 of an operating parameter variation as a function of an age of a battery. Also in this case, the operating parameter variation may be a capacity loss of the battery 102. This data shown in Fig. 5 may be an average data based on experimental data from a plurality of batteries. Such data may thus be experimental usage data from a plurality of batteries, from e.g. hundreds or even thousands of batteries. As an example, in the step of estimating a first variation based on an age, if the battery 102 age is about 8 years, thus it is received from a control unit in the vehicle that the age is 8 years, from the historical data 502 it is found that the operating parameter variation is about 12%.

Although described as a capacity loss in Fig. 4 and Fig. 5, the operating parameter may also be an electrical resistance, thus the operating parameter variation is an electrical resistance increase in that case.

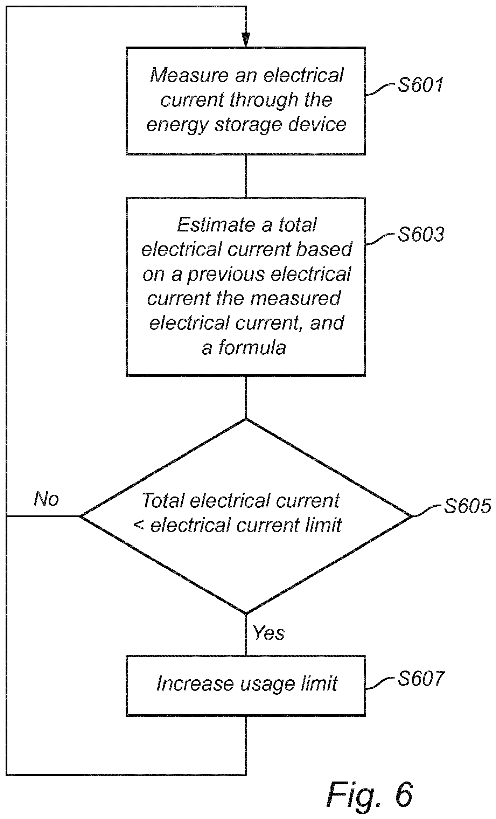

Fig. 6 provides a flow-chart of additional steps which may be performed in parallel with the steps described with reference to Fig. 3. In a first step S601, an electrical current ($i_k$) through the energy storage device 102 is determined. This may be performed by the electric current sensor 202 and the measured electrical current data may be sent to the control unit 204. In a subsequent step S603, a total electrical current ($I_{k+1}$) may be estimated based on a previously estimated electrical current ($I_k$) through the energy storage device 102, on the determined (i.e. measured) electrical current ($i_k$) and based on a formula. The total electrical current may be estimated by the control unit 204 based on the formula for which an algorithm may be stored in the data storage 212. Furthermore, the previously estimated electrical current ($I_k$) may also be stored in the data storage 212, thus being accessible to the control unit 204 together with the formula. If it is determined in step S605 that the total electrical current does not exceed a predefined electrical current limit, a usage limit increased in step S607. This usage limit may be the same as described with reference to the previous drawings showing exemplary embodiments. Subsequently, the method returns to step S601 or may be terminated. If it is determined in step S605 that the total electrical current does exceed the predefined electrical current limit, the method may return to step S601 or the method may be terminated. Note that the predefined electrical current limit may be adapted, thus the limit may change from a first iteration to a second iteration of the method described in Fig. 6, depending on e.g. the amount of usage and the age of the energy storage device. Alternatively or additionally, the limit is fixed. Furthermore, the formula may be given by:

$$I_{k+1} = \sqrt{wI_k + i_k^2(1-w)}$$

where $I_k$ is the calculated total current in the k-th calculation, $i_k$ is the measured electrical current, and $w = \tau/(\tau+T)$ where $\tau$ is a time constant and T is the time from a first calculation of a first total electrical current with the formula to a second calculation of a second total electrical current with the formula, and the time between measurements of the measured current ($i_k$, $i_{k+1}$) for the first and the second total electrical currents, respectively.

An example implementation of an exemplary embodiment of the invention will now be described. Firstly, a value of a travel parameter may be determined. For example, the value of the travel parameter may be a travelled distance of 250 kilometers. Moreover, an age of the battery 102 may be determined to be 8 years. From the travelled distance, a first variation of an operating parameter may be determined from historical data 402. In this example, the operating parameter may be a capacity of the battery, and the operating parameter variation is thereby a capacity loss. From the historical data 402, the first capacity loss corresponding to the travelled distance of 250 kilometers is about 13%. In a similar way, from historical data 502, a capacity loss of about 12% may be determined based on the data 502 and the age of 8 years. Next, an actual capacity loss of the battery 102 is determined by a control unit 204 in the vehicle 100. The actual capacity loss is determined as the capacity loss since the manufacturing of the battery 102. In this example, the actual capacity loss may be 16%. A first difference (dQ1) between the actual capacity loss and the first capacity variation (13%) is then 3%. Furthermore, a second difference (dQ2) between the actual capacity loss and the second capacity variation (12%) is then 4%. In a next step one of the two differences is chosen according to a criterion which may be to choose the smallest one of the two. In this example, the first difference (3%) is the smallest and will therefore be chosen in this example. The choice may be made by the control unit 204. Thereafter, based on the chosen first difference (dQ1) a usage limit adjustment is determined from a predefined set of usage limit adjustments dULA. The predefined set dULA is stored in a look-up table shown as an example in Fig. 7. Fig. 7 shows a first column of operating parameter variation differences dQ and a second column of usage limit adjustments dULA. In this example, the operating parameter variation differences dQ may be capacity loss differences and the predefined usage limit adjustments dULA may be given by a percentage point of adjustment. In this example, the first difference (dQ1) is the chosen difference according to the criterion and is therefore dQ (i.e. dQ=dQ1) in Fig. 7 in this example. Furthermore, if a=2%, b=3%, c=4%, and $x_2$=2% in Fig. 7 and dQ is 3% the corresponding usage limit adjustments dULA is $x_2$=2% points. This means that the usage limit may be adjusted by 2% points. Assuming in this example that the usage limit is the maximum state of charge ($SOC_{max}$) which may be for example $SOC_{max}$=90%, the adjusted usage limit may be $SOC_{max\_adjusted}$=92%.

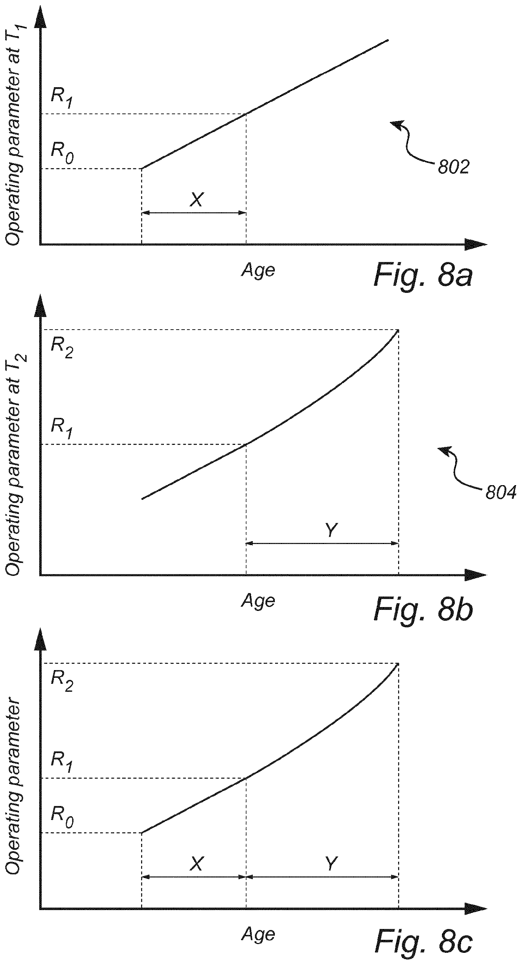

The temperature of the energy storage cell 103 also influences the aging of the energy storage cell 103. Thus, the operating parameter variation versus age shown in Fig. 5 will be different depending on the temperature of the energy storage cell 103. In this case, the step of estimating a second variation of the operating parameter based on the age of the energy storage device from a second set of historical data relating the operating parameter to an age of an energy storage device, may comprise combining more than one set of historical data where sets of historical data may relate to aging of the energy storage device at different temperatures as is shown in Figs 8a-b. For example, if the energy storage device was at a first temperature $T_1$ during e.g. 40% of the time of aging (i.e. x in the drawing Fig. 8a corresponds to 40% of the aging during the present cycle) and at a temperature $T_2$ during e.g. 60% of the time of aging (i.e. y in the drawing Fig. 8b corresponds to 40% of the aging during the present cycle), then the change in operating parameter (e.g. resistance R) during the first time (x) while the energy storage device was at the first temperature $T_1$ may be obtained from a first set of historical data 802 (shown in Fig. 8a) relating the operating parameter versus age for the first temperature $T_1$. As is indicated in Fig. 8a this variation in operating parameter is from $R_0$ to $R_1$. However, the aging is then only 40% of the total aging in the cycle (with time constant T) since the energy storage device was only at the first temperature during 40% of the time of aging. Subsequently, a change in operating parameter while the energy storage device was at the second temperature $T_2$ during the remaining 60% of the time (of the present cycle) indicated by y in Fig. 8b may be obtained from a second set of historical data 804 (shown in Fig. 8b) relating the operating parameter versus age for the second temperature $T_2$. The aging is then only 60% of the total aging. The resulting variation of the operating parameter is from $R_0$ to $R_2$ is used as the estimated second variation of the operating parameter. The total operating parameter versus age is shown in Fig. 8c where the operating parameter versus age during the first time x and at temperature $T_1$ is obtained from the historical data 802 in Fig. 8a, and the operating parameter versus age during the second time y and at temperature $T_2$ is obtained from the historical data 804 in Fig. 8b. Although exemplified by the operating parameter being electrical resistance (R), the described method with reference to Fig. 8a-c may equally well be used for the operating parameter being capacity.

The described method with reference to Fig. 8a-c is equally applicable to the case of the operating parameter being based on the travel parameter instead of the above described age.

Furthermore, the usage limit may also be adjusted depending on the temperature of the energy storage device. For example, the usage limit may be increased if the temperature of the energy storage device is increased.

Additionally, variations to the disclosed embodiments can be understood and effected by the skilled person in practicing the claimed invention, from a study of the drawings, the disclosure, and the appended claims. For example, the data storage may be data storage of the control unit, e.g. internal data storage. Alternatively or additionally, the data storage may be external to the control unit.

Furthermore, the predefined usage limit adjustments may be implemented to increase or decrease the previous usage limit. For example, if the usage limit is a lower state of charge, it may be advantageous to adjust the usage limit to an even lower state of charge in order to provide a user of the vehicle an increased driving distance. Furthermore, even if the operating parameter variations are described as a percentage, they may equally well be absolute numbers or ratios and are thus not limited to a percentage value.

**Claims**

1. A method for determining a usage limit for an energy storage device (102) arranged to provide energy to a vehicle (100), said method comprising the steps of:

   determining (S301) a value of a travel parameter of the energy storage device, said value of said travel parameter being related to a total power usage of the energy storage device,,
   estimating (S305) a first variation of an operating parameter of said energy storage device based on said value of said travel parameter from a first set (402) of historical data relating a variation of the operating parameter to said travel parameter, wherein said first set of historical data includes measurement data from previous measurements on a plurality of energy storage devices,
   estimating an actual variation of said operating parameter for said energy storage device based on data collected during operation of the vehicle related to actual usage of said energy storage device in said vehicle, said data being provided by a control unit in the vehicle,

calculating (S309) a first operating parameter variation difference (dQ1) between said actual variation and said first variation of said operating parameter,

from said first operating parameter variation difference, determining (S315) an usage limit adjustment from a set of predefined usage limit adjustments (dULA),

determining (S317) said usage limit by adjusting a previous usage limit based on said usage limit adjustment.

2. The method according to claim 1, wherein said operating parameter is a capacity of said energy storage device, or wherein said operating parameter is an internal electrical resistance of said energy storage device.

3. The method according to claim 2, wherein, if said operating parameter is a capacity of said energy storage device said variation of an operating parameter is a capacity loss.

4. The method according to any one of the preceding claims, comprising:

determining both of said value of said travel parameter and said age,

determining both of said first variation of said operating parameter and said second variation of said operating parameter,

determining both of said first operating parameter variation difference (dQ1) and said second operating parameter variation difference (dQ2),

choosing (S313) one of said first operating parameter variation difference and said second operating parameter variation difference according to a predefined criterion,

wherein, for said chosen operating parameter variation difference, determining (S315) said usage limit adjustment from said set of predefined usage limit adjustments (dULA).

5. The method according to claim 4, wherein, if said operating parameter is a capacity of said energy storage device, said first variation is a first capacity loss, said second variation is a second capacity loss, said actual variation is an actual capacity loss, thereby said first capacity variation difference is a first capacity loss difference (dQ1) and said second capacity variation difference (dQ2) is a second capacity loss difference,

wherein the step of choosing according to a predefined criterion includes:

choosing the smallest one of said first capacity loss difference and said second capacity loss difference.

6. The method according to any one of the preceding claims, wherein said travel parameter is a travelled distance of said vehicle or a total energy usage of said energy storage device.

7. The method according to any one the preceding claims, further comprising:

measuring (S601) an electrical current ($i_k$) through said energy storage device,

estimating (S603) a total electrical current ($I_{k+1}$) based on a previously estimated electrical current ($I_k$), said measured electrical current and a formula,

if said total current is below a predefined electrical current limit, increasing (S605) said usage limit.

8. The method according to claim 7, wherein said formula is $I_{k+1} = \sqrt{w I_k + i_k^2 (1-w)}$ where $I_k$ is the calculated total electrical current in the k-th calculation, $i_k$ is the measured electrical current, and $w = \tau/(\tau + T)$ where $\tau$ is a time constant and T is the time from a first calculation of a first total electrical current with said formula to a second calculation of a second total electrical current with said formula, and the time between measurements of said measured current ($i_k$, $i_{k+1}$) for said first and said second total electrical currents, respectively.

9. The method according to any one of the preceding claims, comprising a step of monitoring a temperature of said energy storage device, wherein each of said first and/or second variation of said operating parameter of said energy storage device is determined from more than one set of historical data (802, 804) associated with a respective temperature.

10. The method according to any one of the preceding claims, wherein said first and second set of historical data are based on experimental usage data from a plurality of energy storage devices.

11. The method according to any one of the preceding claims, wherein said usage limit is an upper state of charge limit, or a lower state of charge limit, or an upper voltage limit, or a lower voltage limit, or an upper current limit, or a lower current limit or an upper power limit or a lower power limit.

12. A system (200) for determining a usage limit for an energy storage device (102) arranged to provide energy to a vehicle (100), said system comprising:

an electric current sensor (202) arranged to measure an electric current passing to or from said energy storage device and a voltage sensor (206) for measuring a voltage of said energy storage device;

a control unit (204) configured to receive electric current data from said electric current sensor;

a data storage (212), said control unit being in communication with said data storage, said data storage having stored a first set of historical data relating a variation of an operating parameter of said energy storage device to a travel parameter of said energy storage device, said first set of historical data are based on experimental usage data from a plurality of energy storage devices, said data storage further having stored a set of predefined usage limit adjustment values, wherein said control unit is configured to:

determine a travel parameter value related to an amount of usage of said energy storage device,

estimate a first variation of an operating parameter of said energy storage device based on said travel parameter value from said first set of historical data,

estimate an actual variation of said operating parameter for said energy storage device based on said data received from said electric current sensor and said voltage sensor,

calculate a first operating parameter variation difference between said actual variation and said first variation of said operating parameter,

from said first operating parameter variation difference, determining (S315) an usage limit adjustment from a set of predefined usage limit adjustments (dULA),

determine said usage limit by adjusting a previous usage limit stored on said data storage based on said usage limit adjustment.

13. The system according to claim 12, further comprising said energy storage device.

14. The system according to any one of claims 12 or 13, further comprising a temperature sensor (208) arranged to measure the temperature of said energy storage device, wherein said control unit is configured to receive temperature data from said temperature sensor, and wherein to estimate said actual variation of said operating parameter is based at least partly on said received temperature data.

15. Vehicle comprising a system according to any of claims 12 to 14 arranged in said vehicle.

16. A method for determining a usage limit for an energy storage device (102) arranged to provide energy to a vehicle (100), said method comprising the steps of:

determining (S303) an age since manufacturing of said energy storage device,

estimating (S307) a second variation of an operating parameter of said energy storage device based on said age of said energy storage device from a second set (502) of historical data relating a variation of said operating parameter to an age of an energy storage device, wherein second set of historical data includes measurement data from previous measurements on a plurality of energy storage devices,

estimating an actual variation of said operating parameter for said energy storage device based on data collected during operation of the vehicle related to actual usage of said energy storage device in said vehicle, said data being provided by a control unit in the vehicle,

calculating (S311) a second operating parameter variation difference (dQ2) between said actual variation and the second variation of said operating parameter,

from said second operating parameter variation difference, determining (S315) an usage limit adjustment from a set of predefined usage limit adjustments (dULA),

determining (S317) said usage limit by adjusting a previous usage limit based on said usage limit adjustment.

17. A system (200) for determining a usage limit for an energy storage device (102) arranged to provide energy to a vehicle (100), said system comprising:

an electric current sensor (202) arranged to measure an electric current passing to or from said energy storage device and a voltage sensor (206) for measuring a voltage of said energy storage device;

a control unit (204) configured to receive electric current data from said electric current sensor;

a data storage (212), said control unit being in communication with said data storage, said data storage having stored a second set of historical data relating a variation of said operating parameter to an age of said energy storage device, said second set of historical data are based on experimental usage data from a plurality of energy storage devices, said data storage further having stored a set of predefined usage limit adjustment values, wherein said control unit is configured to:

determine a travel parameter value related to an amount of usage of said energy storage device,

estimate a second variation of said operating parameter of said energy storage device based on said age of said energy storage device from said second set of historical data,

estimate an actual variation of said operating parameter for said energy storage device based on said data received from said electric current sensor and said voltage sensor,

calculate a second operating parameter variation difference between said actual variation and the second variation of said operating parameter,

from second operating parameter variation difference, determining (S315) an usage limit adjustment from a set of predefined usage limit adjustments (dULA),

determine said usage limit by adjusting a previous usage limit stored on said data storage based on said usage limit adjustment.

## Patentansprüche

1. Verfahren zum Bestimmen einer Nutzungsgrenze für eine Energiespeichereinrichtung (102), ausgelegt zum Liefern von Energie an ein Fahrzeug (100), wobei das Verfahren die folgenden Schritte umfasst:

Bestimmen (S301) eines Werts eines Reiseparameters der Energiespeichereinrichtung, wobei der Wert des Reiseparameters zu einer Gesamtleistungsnutzung der Energiespeichereinrichtung in Beziehung steht, Schätzen (S305) einer ersten Variation eines Arbeitsparameters der Energiespeichereinrichtung auf Basis des Werts des Reiseparameters von einem ersten Satz (402) von historischen Daten, die eine Variation des Arbeitsparameters zu dem Reiseparameter in Beziehung setzen, wobei der erste Satz von historischen Daten Messdaten von vorausgegangenen Messungen an mehreren Energiespeichereinrichtungen enthält, Schätzen einer tatsächlichen Variation des Arbeitsparameters für die Energiespeichereinrichtung auf Basis von während des Betriebs des Fahrzeugs gesammelten Daten bezüglich einer tatsächlichen Nutzung der Energiespeichereinrichtung in dem Fahrzeug, wobei die Daten durch eine Steuereinheit in dem Fahrzeug geliefert werden, Berechnen (S309) einer ersten Arbeitsparameter-Variationsdifferenz (dQ1) zwischen der tatsächlichen Variation und der ersten Variation des Arbeitsparameters,

anhand der ersten Arbeitsparameter-Variationsdifferenz Bestimmen (S315) einer Nutzungsgrenzenverstellung von einem Satz von vordefinierten Nutzungsgrenzenverstellungen (dULA), Bestimmen (S317) der Nutzungsgrenze durch Verstellen einer vorausgegangenen Nutzungsgrenze auf Basis der Nutzungsgrenzenverstellung.

2. Verfahren nach Anspruch 1, wobei der Arbeitsparameter eine Kapazität der Energiespeichereinrichtung ist oder wobei der Arbeitsparameter ein interner elektrischer Widerstandswert der Energiespeichereinrichtung ist.

3. Verfahren nach Anspruch 2, wobei, falls der Arbeitsparameter eine Kapazität der Energiespeichereinrichtung ist, die Variation eines Arbeitsparameters ein Kapazitätsverlust ist.

4. Verfahren nach einem der vorhergehenden Ansprüche, umfassend:

Bestimmen beides des Werts des Reiseparameters und des Alters, Bestimmen beides der ersten Variation des Arbeitsparameters und der zweiten Variation des Arbeitsparameters, Bestimmen beides der ersten Arbeitsparameter-Variationsdifferenz (dQ1) und der zweiten Arbeitsparameter-Variationsdifferenz (dQ2), Wählen (S313) einer der ersten Arbeitsparameter-Variationsdifferenz und der zweiten Arbeitsparameter-Variationsdifferenz gemäß einem vordefinierten Kriterium, wobei für die gewählte Arbeitsparameter-Variationsdifferenz, Bestimmen (S315) der Nutzungsgrenzenverstellung anhand des Satzes von vordefinierten Nutzungsgrenzenverstellungen (dULA) .

5. Verfahren nach Anspruch 4, wobei, falls der Arbeitsparameter eine Kapazität der Energiespeichereinrichtung ist, die erste Variation ein erster Kapazitätsverlust ist, die zweite Variation eine zweiter Kapazitätsverlust ist, die tatsächliche Variation ein tatsächlicher Kapazitätsverlust ist, wodurch die erste Kapazitätsvariationsdifferenz eine erste Kapazitätsverlustdifferenz (dQ1) ist und die zweite Kapazitätsvariationsdifferenz (dQ2) eine Kapazitätsverlustdifferenz ist, wobei der Schritt des Wählens gemäß einem vordefinierten Kriterium beinhaltet: Wählen der kleinsten der ersten Kapazitätsverlustdifferenz und der zweiten Kapazitätsverlustdifferenz.

**6.** Verfahren nach einem der vorhergehenden Ansprüche, wobei der Reiseparameter eine zurückgelegte Distanz des Fahrzeugs oder eine Gesamtenergienutzung der Energiespeichereinrichtung ist.

**7.** Verfahren nach einem der vorhergehenden Ansprüche, weiter umfassend:

Messen (S601) eines elektrischen Stroms ($i_k$) durch die Energiespeichereinrichtung,
Schätzen (S603) eines gesamten elektrischen Stroms ($I_{k+1}$) auf Basis eines zuvor geschätzten elektrischen Stroms ($I_k$), des gemessenen elektrischen Stroms und einer Formel,
falls der gesamte Strom unter einer vordefinierten Grenze für den elektrischen Strom ist, Erhöhen (S605) der Nutzungsgrenze.

**8.** Verfahren nach Anspruch 7, wobei die Formel lautet

$$I_{k+1} = \sqrt{wI_k + i_k^2(1-w)}$$ wobei $I_k$ der berechnete gesamte elektrische Strom in der k-ten Berechnung ist, $i_k$ der gemessene elektrische Strom ist und $w = \tau/(\tau + T)$, wobei $\tau$ eine Zeitkonstante ist und T die Zeit ab einer ersten Berechnung eines ersten gesamten elektrischen Stroms mit der Formel zu einer zweiten Berechnung eines zweiten gesamten elektrischen Stroms mit der Formel und die Zeit zwischen Messungen des gemessenen Stroms ($i_k, i_{k+1}$) für den ersten bzw. den zweiten gesamten elektrischen Strom ist.

**9.** Verfahren nach einem der vorhergehenden Ansprüche, umfassend einen Schritt des Überwachens einer Temperatur der Energiespeichereinrichtung, wobei jede der ersten und/oder zweiten Variation des Arbeitsparameters der Energiespeichereinrichtung anhand von mehr als einem Satz von historischen Daten (802, 804), mit einer jeweiligen Temperatur assoziiert, ist.

**10.** Verfahren nach einem der vorhergehenden Ansprüche, wobei der erste und zweite Satz von historischen Daten auf Versuchsnutzungsdaten von mehreren Energiespeichereinrichtungen basieren.

**11.** Verfahren nach einem der vorhergehenden Ansprüche, wobei die Nutzungsgrenze eine obere Ladezustandsgrenze oder eine untere Ladezustandsgrenze oder eine obere Spannungsgrenze oder eine untere Spannungsgrenze oder eine obere Stromgrenze oder eine untere Stromgrenze oder eine obere Leistungsgrenze oder eine untere Leistungsgrenze ist.

**12.** System (200) zum Bestimmen einer Nutzungsgrenze für eine Energiespeichereinrichtung (102), ausgelegt zum Liefern von Energie an ein Fahrzeug (100), wobei das System umfasst:

einen Elektrischer-Strom-Sensor (202), ausgelegt zum Messen eines elektrischen Stroms, der zu oder von der Energiespeichereinrichtung fließt, und einen Spannungssensor (206) zum Messen einer Spannung der Energiespeichereinrichtung;
eine Steuereinheit (204), konfiguriert zum Empfangen von Elektrischer-Strom-Daten von dem Elektrischer-Strom-Sensor;
eine Datenablage (212), wobei die Steuereinheit in Kommunikation mit der Datenablage steht, wobei die Datenablage einen ersten Satz von historischen Daten, die eine Variation eines Arbeitsparameters der Energiespeichereinrichtung zu einem Reiseparameter der Energiespeichereinrichtung in Beziehung setzen, gespeichert hat, der erste Satz von historischen Daten auf Versuchsnutzungsdaten von mehreren Energiespeichereinrichtungen basiert, die Datenablage weiter einen Satz von vordefinierten Nutzungsgrenzverstellungswerten gespeichert hat, wobei die Steuereinheit konfiguriert ist zum:

Bestimmen eines Reiseparameterwerts bezüglich einer Menge von Nutzungen der Energiespeichereinrichtung,
Schätzen einer ersten Variation eines Arbeitsparameters der Energiespeichereinrichtung auf Basis des Reiseparameterwerts anhand des ersten Satzes von historischen Daten,
Schätzen einer tatsächlichen Variation des Arbeitsparameters für die Energiespeichereinrichtung auf Basis der von dem Elektrischer-Strom-Sensor und dem Spannungssensor empfangenen Daten,
Berechnen einer ersten Arbeitsparameter-Variationsdifferenz zwischen der tatsächlichen Variation und der ersten Variation des Arbeitsparameters,
anhand der ersten Arbeitsparameter-Variationsdifferenz Bestimmen (S315) einer Nutzungsgrenzenverstellung anhand eines Satzes von vordefinierten Nutzungsgrenzenverstellungen (dULA),
Bestimmen der Nutzungsgrenze durch Verstellen einer auf der Datenablage gespeicherten vorausgegangenen Nutzungsgrenze auf Basis der Nutzungsgrenzenverstellung.

**13.** System nach Anspruch 12, weiter umfassend die Energiespeichereinrichtung.

**14.** System nach einem von Ansprüchen 12 oder 13, weiter umfassend einen Temperatursensor (208), ausgelegt zum Messen der Temperatur der Energiespeichereinrichtung, wobei die Steuereinheit konfiguriert ist zum Empfangen von Temperaturdaten von dem Temperatursensor, und wobei das Schätzen der tatsächlichen Variation des Arbeitsparameters mindestens teilweise auf den empfangenen Temperaturdaten basiert.

**15.** Fahrzeug umfassend ein System nach einem der Ansprüche 12 bis 14, angeordnet in dem Fahrzeug.

**16.** Verfahren zum Bestimmen einer Nutzungsgrenze für eine Energiespeichereinrichtung (102), ausgelegt zum Liefern von Energie an ein Fahrzeug (100), wobei das Verfahren die folgenden Schritte umfasst:

Bestimmen (S303) eines Alters seit der Herstellung der Energiespeichereinrichtung,
Schätzen (S307) einer zweiten Variation eines Arbeitsparameters der Energiespeichereinrichtung auf Basis des Alters der Energiespeichereinrichtung anhand eines zweiten Satzes (502) von historischen Daten, die eine Variation des Arbeitsparameters zu einem Alter einer Energiespeichereinrichtung in Beziehung setzen, wobei der zweite Satz von historischen Daten Messdaten von vorausgegangenen Messungen an mehreren Energiespeichereinrichtungen enthält,
Schätzen einer tatsächlichen Variation des Arbeitsparameters für die Energiespeichereinrichtung auf Basis von während des Betriebs des Fahrzeugs gesammelten Daten bezüglich einer tatsächlichen Nutzung der Energiespeichereinrichtung in dem Fahrzeug, wobei die Daten durch eine Steuereinheit in dem Fahrzeug geliefert werden,
Berechnen (S311) einer zweiten Arbeitsparameter-Variationsdifferenz (dQ2) zwischen der tatsächlichen Variation und der zweiten Variation des Arbeitsparameters,
anhand der zweiten Arbeitsparameter-Variationsdifferenz Bestimmen (S315) einer Nutzungsgrenzenverstellung anhand eines Satzes von vordefinierten Nutzungsgrenzenverstellungen (dULA),
Bestimmen (S317) der Nutzungsgrenze durch Verstellen einer vorausgegangenen Nutzungsgrenze auf Basis der Nutzungsgrenzenverstellung.

**17.** System (200) zum Bestimmen einer Nutzungsgrenze für eine Energiespeichereinrichtung (102), ausgelegt zum Liefern von Energie an ein Fahrzeug (100), wobei das System umfasst:

einen Elektrischer-Strom-Sensor (202), ausgelegt zum Messen eines elektrischen Stroms, der zu oder von der Energiespeichereinrichtung fließt, und einen Spannungssensor (206) zum Messen einer Spannung der Energiespeichereinrichtung;
eine Steuereinheit (204), konfiguriert zum Empfangen von Elektrischer-Strom-Daten von dem Elektrischer-Strom-Sensor;
eine Datenablage (212), wobei die Steuereinheit in Kommunikation mit der Datenablage steht, wobei die Datenablage einen zweiten Satz von historischen Daten, die eine Variation eines Arbeitsparameters zu einem Alter der Energiespeichereinrichtung in Beziehung setzt, wobei der zweite Satz von historischen Daten auf Versuchsnutzungsdaten von mehreren Energiespeichereinrichtungen basiert, die Datenablage weiter einen Satz von vordefinierten Nutzungsgrenzverstellungswerten gespeichert hat, wobei die Steuereinheit konfiguriert ist zum:

Bestimmen eines Reiseparameterwerts bezüglich einer Menge von Nutzungen der Energiespeichereinrichtung,
Schätzen einer zweiten Variation eines Arbeitsparameters der Energiespeichereinrichtung auf Basis des Alters der Energiespeichereinrichtung anhand des zweiten Satzes von historischen Daten, Schätzen einer tatsächlichen Variation des Arbeitsparameters für die Energiespeichereinrichtung auf Basis der von dem Elektrischer-Strom-Sensor und dem Spannungssensor empfangenen Daten,
Berechnen einer zweiten Arbeitsparameter-Variationsdifferenz zwischen der tatsächlichen Variation und der zweiten Variation des Arbeitsparameters,
anhand der zweiten Arbeitsparameter-Variationsdifferenz Bestimmen (S315) einer Nutzungsgrenzenverstellung anhand eines Satzes von vordefinierten Nutzungsgrenzenverstellungen (dULA),
Bestimmen der Nutzungsgrenze durch Verstellen einer auf der Datenablage gespeicherten vorausgegangenen Nutzungsgrenze auf Basis der Nutzungsgrenzenverstellung.

**Revendications**

**1.** Procédé de détermination d'une limite d'utilisation pour un dispositif (102) de stockage d'énergie agencé pour fournir de l'énergie à un véhicule (100), ledit procédé comportant les étapes consistant à :

déterminer (S301) une valeur d'un paramètre de déplacement du dispositif de stockage d'énergie, ladite valeur dudit paramètre de déplacement étant liée à une utilisation totale d'électricité du dispositif de stockage d'énergie, estimer (S305) une première variation d'un paramètre de fonctionnement dudit dispositif de stockage d'énergie d'après ladite valeur dudit paramètre de déplacement à partir d'un premier ensemble (402) de données historiques liant une variation du paramètre de fonctionnement audit paramètre de déplacement, ledit premier ensemble de données historiques comprenant des données de mesures provenant de mesures précédentes sur une pluralité de dispositifs de stockage d'énergie,

estimer une variation réelle dudit paramètre de fonctionnement pour ledit dispositif de stockage d'énergie d'après des données recueillies pendant le fonctionnement du véhicule liées à une utilisation réelle dudit dispositif de stockage d'énergie dans ledit véhicule, lesdites données étant fournies par une unité de commande dans le véhicule,

calculer (S309) une première différence de variation de paramètre de fonctionnement (dQ1) entre ladite variation réelle et ladite première variation dudit paramètre de fonctionnement,

à partir de ladite première différence de variation de paramètre de fonctionnement, déterminer (S315) un ajustement de limite d'utilisation dans un ensemble d'ajustements de limite d'utilisation (dULA) prédéfinis, déterminer (S317) ladite limite d'utilisation en ajustant une précédente limite d'utilisation d'après ledit ajustement de limite d'utilisation.

2. Procédé selon la revendication 1, ledit paramètre de fonctionnement étant une capacité dudit dispositif de stockage d'énergie, ou ledit paramètre de fonctionnement étant une résistance électrique interne dudit dispositif de stockage d'énergie.

3. Procédé selon la revendication 2, ladite variation d'un paramètre de fonctionnement étant une perte de capacité, si ledit paramètre de fonctionnement est une capacité dudit dispositif de stockage d'énergie.

4. Procédé selon l'une quelconque des revendications précédentes, comportant les étapes consistant à :

déterminer à la fois ladite valeur dudit paramètre de déplacement et ledit âge,
déterminer à la fois ladite première variation dudit paramètre de fonctionnement et ladite seconde variation dudit paramètre de fonctionnement,
déterminer à la fois ladite première différence de variation de paramètre de fonctionnement (dQ1) et ladite seconde différence de variation de paramètre de fonctionnement (dQ2),
choisir (S313) une différence parmi ladite première différence de variation de paramètre de fonctionnement et ladite seconde différence de variation de paramètre de fonctionnement selon un critère prédéfini,
pour ladite différence choisie de variation de paramètre de fonctionnement, déterminer (S315) ledit ajustement de limite d'utilisation dans ledit ensemble d'ajustements de limite d'utilisation (dULA) prédéfinis.

5. Procédé selon la revendication 4 où, si ledit paramètre de fonctionnement est une capacité dudit dispositif de stockage d'énergie, ladite première variation est une première perte de capacité, ladite seconde variation est une seconde perte de capacité, ladite variation réelle est une perte réelle de capacité, ladite première différence de variation de capacité étant ainsi une première différence de perte de capacité (dQ1) et ladite seconde différence de variation de capacité (dQ2) étant une seconde différence de perte de capacité,
l'étape de choix selon un critère prédéfini comprenant :
le choix de la plus petite parmi ladite première différence de perte de capacité et ladite seconde différence de perte de capacité.

6. Procédé selon l'une quelconque des revendications précédentes, ledit paramètre de déplacement étant une distance parcourue dudit véhicule ou une utilisation totale d'énergie dudit dispositif de stockage d'énergie.

7. Procédé selon l'une quelconque des revendications précédentes, comportant en outre les étapes consistant à :

mesurer (S601) un courant électrique ($i_k$) à travers ledit dispositif de stockage d'énergie,
estimer (S603) un courant électrique total ($I_{k+1}$) d'après un courant électrique ($I_k$) estimé précédemment, ledit courant électrique mesuré et une formule,
si ledit courant total est inférieur à une limite prédéfinie de courant électrique, augmenter (S605) ladite limite d'utilisation.

8. Procédé selon la revendication 7, ladite formule étant $I_{k+1} = \sqrt{wI_k + i_k^2(1-w)}$ où $I_k$ est le courant électrique total calculé lors du kième calcul, $i_k$ est le courant électrique mesuré, et $w = \tau/(\tau+T)$ où $\tau$ est une constante de temps et T est le temps d'un premier calcul d'un premier courant électrique total avec ladite formule à un second calcul d'un second courant électrique total avec ladite formule, et le temps entre des mesures dudit courant mesuré ($i_k$, $i_{k+1}$) pour lesdits premier et second courants électriques totaux, respectivement.

9. Procédé selon l'une quelconque des revendications précédentes, comportant une étape de surveillance d'une température dudit dispositif de stockage d'énergie, chacune desdites première et/ou seconde variations dudit paramètre de fonctionnement dudit dispositif de stockage d'énergie étant déterminée à partir de plus d'un ensemble de données historiques (802, 804) associées à une température respective.

10. Procédé selon l'une quelconque des revendications précédentes, lesdits premier et second ensembles de données historiques étant basés sur des données expérimentales d'utilisation provenant d'une pluralité de dispositifs de stockage d'énergie.

11. Procédé selon l'une quelconque des revendications précédentes, ladite limite d'utilisation étant une limite supérieure d'état de charge, ou une limite inférieure d'état de charge, ou une limite supérieure de tension, ou une limite inférieure de tension, ou une limite supérieure de courant, ou une limite inférieure de courant ou une limite supérieure de puissance ou une limite inférieure de puissance.

12. Système (200) de détermination d'une limite d'utilisation pour un dispositif (102) de stockage d'énergie agencé pour fournir de l'énergie à un véhicule (100), ledit système comportant :

un capteur (202) de courant électrique agencé pour mesurer un courant électrique passant à destination ou en provenance dudit dispositif de stockage d'énergie et un capteur (206) de tension servant à mesurer une tension dudit dispositif de stockage d'énergie ;
une unité (204) de commande configurée pour recevoir des données de courant électrique en provenance dudit capteur de courant électrique ;
un stockage (212) de données, ladite unité de commande étant en communication avec ledit stockage de données, ledit stockage de données ayant stocké un premier ensemble de données historiques liant une variation d'un paramètre de fonctionnement dudit dispositif de stockage d'énergie à un paramètre de déplacement dudit dispositif de stockage d'énergie, ledit premier ensemble de données historiques étant basé sur des données expérimentales d'utilisation provenant d'une pluralité de dispositifs de stockage d'énergie, ledit stockage de données ayant stocké en outre un ensemble de valeurs prédéfinies d'ajustement de limite d'utilisation, ladite unité de commande étant configurée pour :

déterminer une valeur de paramètre de déplacement liée à une quantité d'utilisation dudit dispositif de stockage d'énergie,
estimer une première variation d'un paramètre de fonctionnement dudit dispositif de stockage d'énergie d'après ladite valeur de paramètre de déplacement à partir dudit premier ensemble de données historiques,
estimer une variation réelle dudit paramètre de fonctionnement pour ledit dispositif de stockage d'énergie d'après lesdites données reçues en provenance dudit capteur de courant électrique et dudit capteur de tension,
calculer une première différence de variation de paramètre de fonctionnement entre ladite variation réelle et ladite première variation dudit paramètre de fonctionnement,
à partir de ladite première différence de variation de paramètre de fonctionnement, déterminer (S315) un ajustement de limite d'utilisation dans un ensemble d'ajustements de limite d'utilisation (dULA) prédéfinis,
déterminer ladite limite d'utilisation en ajustant une précédente limite d'utilisation conservée sur ledit stockage de données d'après ledit ajustement de limite d'utilisation.

13. Système selon la revendication 12, comportant en outre ledit dispositif de stockage d'énergie.

14. Système selon l'une quelconque des revendications 12 et 13, comportant en outre un capteur (208) de température agencé pour mesurer la température dudit dispositif de stockage d'énergie, ladite unité de commande étant configurée pour recevoir des données de température en provenance dudit capteur de température, et l'estimation de ladite variation réelle dudit paramètre de fonctionnement étant basée au moins partiellement sur lesdites données de température reçues.

15. Véhicule comportant un système selon l'une quelconque des revendications 12 à 14 agencé dans ledit véhicule.

16. Procédé de détermination d'une limite d'utilisation pour un dispositif (102) de stockage d'énergie agencé pour fournir de l'énergie à un véhicule (100), ledit procédé comportant les étapes consistant à :

déterminer (S303) un âge depuis la fabrication dudit dispositif de stockage d'énergie,

estimer (S307) une seconde variation d'un paramètre de fonctionnement dudit dispositif de stockage d'énergie d'après ledit âge dudit dispositif de stockage d'énergie à partir d'un second ensemble (502) de données historiques liant une variation dudit paramètre de fonctionnement à un âge d'un dispositif de stockage d'énergie, le second ensemble de données historiques comprenant des données de mesures provenant de mesures précédentes sur une pluralité de dispositifs de stockage d'énergie,

estimer une variation réelle dudit paramètre de fonctionnement pour ledit dispositif de stockage d'énergie d'après des données recueillies pendant le fonctionnement du véhicule liées à une utilisation réelle dudit dispositif de stockage d'énergie dans ledit véhicule, lesdites données étant fournies par une unité de commande dans le véhicule,

calculer (S311) une seconde différence de variation de paramètre de fonctionnement (dQ2) entre ladite variation réelle et la seconde variation dudit paramètre de fonctionnement,

à partir de ladite seconde différence de variation de paramètre de fonctionnement, déterminer (S315) un ajustement de limite d'utilisation dans un ensemble d'ajustements de limite d'utilisation (dULA) prédéfinis, déterminer (S317) ladite limite d'utilisation en ajustant une précédente limite d'utilisation d'après ledit ajustement de limite d'utilisation.

**17.** Système (200) de détermination d'une limite d'utilisation pour un dispositif (102) de stockage d'énergie agencé pour fournir de l'énergie à un véhicule (100), ledit système comportant :

un capteur (202) de courant électrique agencé pour mesurer un courant électrique passant à destination ou en provenance dudit dispositif de stockage d'énergie et un capteur (206) de tension servant à mesurer une tension dudit dispositif de stockage d'énergie ;

une unité (204) de commande configurée pour recevoir des données de courant électrique en provenance dudit capteur de courant électrique ;

un stockage (212) de données, ladite unité de commande étant en communication avec ledit stockage de données, ledit stockage de données ayant stocké un second ensemble de données historiques liant une variation dudit paramètre de fonctionnement à un âge dudit dispositif de stockage d'énergie, ledit second ensemble de données historiques étant basés sur des données expérimentales d'utilisation provenant d'une pluralité de dispositifs de stockage d'énergie, ledit stockage de données ayant stocké en outre un ensemble de valeurs prédéfinies d'ajustement de limite d'utilisation, ladite unité de commande étant configurée pour :

déterminer une valeur de paramètre de déplacement liée à une quantité d'utilisation dudit dispositif de stockage d'énergie,

estimer une seconde variation dudit paramètre de fonctionnement dudit dispositif de stockage d'énergie d'après ledit âge dudit dispositif de stockage d'énergie à partir dudit second ensemble de données historiques,

estimer une variation réelle dudit paramètre de fonctionnement pour ledit dispositif de stockage d'énergie d'après lesdites données reçues en provenance dudit capteur de courant électrique et dudit capteur de tension,

calculer une seconde différence de variation de paramètre de fonctionnement entre ladite variation réelle et la seconde variation dudit paramètre de fonctionnement,

à partir de la seconde différence de variation de paramètre de fonctionnement, déterminer (S315) un ajustement de limite d'utilisation dans un ensemble d'ajustements de limite d'utilisation (dULA) prédéfinis, déterminer ladite limite d'utilisation en ajustant une précédente limite d'utilisation conservée sur ledit stockage de données d'après ledit ajustement de limite d'utilisation.

Fig. 1

Fig. 2

Fig. 3

S301 — Determine a value of a travel parameter

S303 — Determine age of the energy storage device

S305 — Estimate a first variation of an operating parameter based on the travel parameter

S307 — Estimate a second variation of an operating parameter based on the age

S308 — Determine actual operating parameter variation

S309 — Determine a first difference between the actual variation of the operating parameter and the first variation

S311 — Determine a second difference between the actual variation of the operating parameter and the second variation

S313 — Choose one of the first or the second difference

S315 — Based on chosen difference determine usage limit adjustment

S317 — Determine usage limit

*Fig. 4*

*Fig. 5*

Fig. 6

| $dQ$ | $dULA$ |
|---|---|
| $dQ < a$ | $0$ |
| $a \leq dQ < b$ | $x_1$ |
| $b \leq dQ < c$ | $x_2$ |
| $c \leq dQ < d$ | $x_3$ |
| $\vdots$ | $\vdots$ |

*Fig. 7*

Fig. 8a

Fig. 8b

Fig. 8c

## REFERENCES CITED IN THE DESCRIPTION

**Patent documents cited in the description**

- EP 2502775 A
- US 20140132214 A
- US 20130043844 A
- US 20140232356 A
- EP 2339361 A